# EUROPEAN PATENT APPLICATION

(11) **EP 4 514 087 A1**
(43) Date of publication of application: **26.02.2025**
(21) Application number: 23919431.9
(22) Date of filing: 16.11.2023
(51) Int. Cl.: H05K 9/00

(54) **ELECTRONIC DEVICE AND SHIELDING MEMBER**

(30) Priority: 02.02.2023 CN 202310120762
(71) Applicant: Honor Device Co., Ltd., Shenzhen, Guangdong 518040 (CN)
(72) Inventor: ZHU, Kaixiang, Shenzhen, Guangdong 518040 (CN); DAI, Xiaomang, Shenzhen, Guangdong 518040 (CN); YI, Chao, Shenzhen, Guangdong 518040 (CN); LIANG, Feng, Shenzhen, Guangdong 518040 (CN)
(74) Representative: Goddar, Heinz J.
(86) International application number: PCT/CN2023/132115
(87) International publication number: WO 2024/159867

(57) **Abstract**

Embodiments of this application provide an electronic device and a shielding member. The electronic device includes a mainboard, a camera apparatus, and a shielding member. The mainboard includes a first connection terminal and a ground terminal. The camera apparatus includes a camera module, a circuit board, and a second connection terminal. The camera module is electrically connected to the circuit board. The second connection terminal is electrically connected to the circuit board. The first connection terminal is electrically connected to the second connection terminal. Accommodating space is formed between the shielding member and the mainboard. The first connection terminal and the second connection terminal are located in the accommodating space. The shielding member includes a shielding frame and a shielding cover that are electrically connected. The shielding frame is connected to the mainboard. The shielding frame is electrically connected to the ground terminal. The shielding cover is connected to the shielding frame. The second connection terminal is electrically connected to the shielding cover. According to the electronic device in the embodiments of this application, a possibility that shooting experience is affected because the camera apparatus is interfered with by a signal.

## Description

This application claims priority to Chinese Patent Application No. 202310120762.4, filed with the China National Intellectual Property Administration on February 2, 2023 and entitled "ELECTRONIC DEVICE AND SHIELDING MEMBER", which is incorporated herein by reference in its entirety.

### TECHNICAL FIELD

Embodiments of this application relate to the field of terminal technologies, and in particular, to an electronic device and a shielding member.

### BACKGROUND

With explosive growth of electronic devices such as smartphones or tablet computers, the electronic device has more functions. Because people expect that the electronic device can meet more function requirements, the electronic device can implement more functions. For example, the electronic device includes a camera apparatus. People expect that camera performance of the electronic device is increasingly high, to obtain a high-resolution image. The camera apparatus includes a camera module, for example, a rear-facing camera module. The camera module is configured to photograph a selected target and form corresponding image information. The camera module includes a light entry part configured to receive light. External light may enter the camera module through the light entry part. The camera module may be electrically connected to a mainboard. For example, the camera module may be electrically connected to the mainboard by using a circuit board, to implement signal interaction. However, when the electronic device performs a shooting function, there is a case in which the camera apparatus is interfered with by a signal. Consequently, a phenomenon such as a screen artifact, stalling, or screen freezing occurs in a shooting interface. This affects shooting experience of the electronic device.

### SUMMARY

Embodiments of this application provide an electronic device and a shielding member, so as to reduce a possibility that shooting experience is affected because a camera apparatus is interfered with by a signal.

A first aspect of this application provides an electronic device, where the electronic device includes a mainboard, a camera apparatus, and a shielding member.

The mainboard includes a first connection terminal and a ground terminal. The camera apparatus includes a camera module, a circuit board, and a second connection terminal. The camera module is electrically connected to the circuit board. The second connection terminal is electrically connected to the circuit board. The first connection terminal is electrically connected to the second connection terminal. Accommodating space is formed between the shielding member and the mainboard. The first connection terminal and the second connection terminal are located in the accommodating space. The shielding member includes a shielding frame and a shielding cover that are electrically connected. The shielding frame is connected to the mainboard. The shielding frame is electrically connected to the ground terminal. The shielding cover is connected to the shielding frame. The second connection terminal is electrically connected to the shielding cover.

In the electronic device of this application, the mainboard includes the first connection terminal and the ground terminal, and the camera apparatus includes the camera module, the circuit board, and the second connection terminal. The first connection terminal is connected to the second connection terminal. The first connection terminal is electrically connected to the second connection terminal. The camera apparatus is communicatively connected to the mainboard, to implement signal interaction. The shielding member is connected to the mainboard, and the shielding member covers the exterior of the first connection terminal and the second connection terminal. The shielding member is electrically connected to the ground terminal of the mainboard, to implement grounding. The second connection terminal is electrically connected to the shielding member. Therefore, the first connection terminal, the second connection terminal, the shielding cover, and the shielding frame may be grounded by using the ground terminal of the mainboard. This helps reduce ground impedance at a connector formed by the first connection terminal and the second connection terminal, to avoid a sudden change in impedance at the connector formed by the first connection terminal and the second connection terminal, and helps eliminate parasitic capacitance formed between the ground terminal of the mainboard and the connector formed by the first connection terminal and the second connection terminal, thereby helping reduce a possibility that an electromagnetic signal interferes with the first connection terminal and the second connection terminal and electromagnetic coupling occurs. Therefore, it is ensured that a signal transmission process between the camera apparatus and the mainboard is stable, so that the electronic device can smoothly perform a shooting function, thereby improving shooting experience. The shielding member may also effectively shield the electromagnetic signal from adversely affecting and interfering with the first connection terminal and the second connection terminal, thereby further helping reduce a possibility that an interaction signal between the camera apparatus and the mainboard is interfered with.

In a possible implementation, the shielding frame is of an annular structure. The first connection terminal is located in the shielding frame.

The shielding frame is disposed around the first connection terminal. Therefore, in any direction, the shielding frame can have a good shielding effect on the first connection terminal.

In a possible implementation, the shielding frame includes a bottom flange, a first side plate, and a top flange. Both the bottom flange and the top flange are connected to the first side plate. The bottom flange is electrically connected to the ground terminal. An outer surface that is of the top flange and that faces away from the mainboard is electrically connected to an inner surface that is of the shielding cover and that faces the mainboard.

The outer surface that is of the top flange and that faces away from the mainboard is electrically connected to the inner surface that is of the shielding cover and that faces the mainboard. This helps implement a relatively large electrical connection area between the shielding cover and the shielding frame, to effectively reduce impedance, so that a good electrical connection state is maintained between the shielding cover and the shielding frame.

In a possible implementation, the outer surface that is of the top flange and that faces away from the mainboard directly abuts against the inner surface that is of the shielding cover and that faces the mainboard, so that the top flange is electrically connected to the shielding cover.

A width of at least a part of the top flange is greater than a width of the bottom flange.

A manner of setting the width of at least a part of the top flange to be relatively large helps increase a contact area between the shielding cover and the shielding frame, to effectively compensate for the contact area between the shielding cover and the shielding frame, and reduce a possibility that the contact area does not meet a requirement because surfaces that are of the shielding cover and the shielding frame and that are used for contact are uneven.

The bottom flange is set to have a relatively small width. This can help reduce an orthographic projection area of the bottom flange on the mainboard when connection strength between the bottom flange and the mainboard is met, thereby reducing space occupation of the mainboard by the bottom flange, and reducing a possibility that a region that is of the mainboard and in which an electronic component can be disposed is reduced because the bottom flange occupies excessive space on the mainboard.

In a possible implementation, the shielding cover and the first side plate are snap-fitted with each other.

A snap-fit manner is used for the shielding cover and the first side plate, to facilitate quick assembly or separation of the shielding cover and the shielding frame, and improve assembly or separation working efficiency.

In a possible implementation, a snap-in part is disposed on one of the shielding cover and the first side plate, and a fitting part is disposed on the other thereof. The snap-in part is snap-fitted with the fitting part.

In a possible implementation, the shielding cover includes a top plate and a second side plate that are connected to each other. The snap-in part is disposed on one of the first side plate and the second side plate, and the fitting part is disposed on the other thereof. The first connection terminal and the second connection terminal are disposed between the top plate and the mainboard. The outer surface that is of the top flange and that faces away from the mainboard is electrically connected to an inner surface that is of the top plate and that faces the mainboard.

In a possible implementation, there are a plurality of second side plates. There is a gap between two adjacent second side plates.

The second side plates are disposed independently. Therefore, in a snap-fit process, when any one of the second side plates is deformed, none of the other second side plates is pulled.

In a possible implementation, the outer surface that is of the top flange and that faces away from the mainboard directly abuts against the inner surface that is of the top plate and that faces the mainboard, so that the top flange is electrically connected to the top plate.

In a possible implementation, the shielding cover and the shielding frame are snap-fitted with each other.

A snap-fit manner is used for the shielding cover and the shielding frame, to facilitate quick assembly or separation of the shielding cover and the shielding frame, and improve assembly or separation working efficiency.

In a possible implementation, a surface that is of the second connection terminal and that faces away from the first connection terminal is bonded to the shielding cover by using a conductive adhesive, so that the second connection terminal is electrically connected to the shielding cover.

In a possible implementation, the electronic device further includes a reinforcement member. At least a part of the reinforcement member is disposed on a side that is of the second connection terminal and that faces away from the first connection terminal. The reinforcement member is of a conductive structure. The reinforcement member is electrically connected to the second connection terminal. The reinforcement member is electrically connected to the shielding cover.

The reinforcement member may provide protection for the second connection terminal, to effectively avoid a case in which structural damage occurs in the second connection terminal because the second connection terminal is impacted by an external force. The shielding member may apply compressive stress to the reinforcement member toward the second connection terminal, to ensure connection reliability and stability between the first connection terminal and the second connection terminal, and reduce a possibility that the second connection terminal is removed from the first connection terminal and is in a disconnected state.

In a possible implementation, the shielding cover directly abuts against the reinforcement member.

The shielding cover of the shielding member is in direct contact with the reinforcement member to implement electrical connection, so that there is no need to dispose an additional structural member for implementing electrical connection between the shielding member and the reinforcement member. This helps reduce a quantity of used parts and assembly operations.

In a possible implementation, the electronic device further includes a conductive member. The conductive member is disposed between the shielding cover and the reinforcement member. The conductive member electrically connects the shielding cover and reinforcement member.

The shielding cover and the reinforcement member may jointly press against the conductive member, to ensure good contact between the conductive member and each of the shielding member and the reinforcement member, and maintain stability of an electrical connection state between the conductive member and each of the shielding member and the reinforcement member.

In a possible implementation, the conductive member is of a flexible structure.

The conductive member may be compressed and deformed. Therefore, when a surface of at least one of the shielding cover of the shielding member and the reinforcement member is uneven, the conductive member may perform compensation through deformation thereof, to ensure that a close fitted and contact state is maintained between the shielding cover of the shielding member and the conductive member and between the reinforcement member and the conductive member. In this way, a good electrical connection state is maintained between the shielding cover of the shielding member and the reinforcement member, to help reduce impedance.

In a possible implementation, the reinforcement member is capacitively coupled to the shielding cover.

The reinforcement member is not in direct contact with the shielding cover, so that a case in which poor contact occurs between the shielding cover and the reinforcement member can be avoided, thereby reducing a possibility that a passive inter-modulation (Passive Inter-Modulation, PIM) problem and a spurious emission (RSE) problem are generated due to poor contact.

In a possible implementation, the electronic device further includes a high dielectric layer. The high dielectric layer is disposed between the reinforcement member and the shielding cover.

Each of the shielding member and the reinforcement member is in non-electrical contact with the high dielectric layer. There is no problem of poor contact in a capacitive coupling manner. Therefore, there is no requirement on stability of contact resistance between the high dielectric layer and each of the shielding member and the reinforcement member. In this way, surface processing such as nickel plating and gold plating does not need to be performed on the shielding member and the reinforcement member. In addition, a location for disposing the high dielectric layer can be freely and flexibly selected based on a design requirement.

In a possible implementation, a material of the high dielectric layer includes a wave-absorbing material.

The high dielectric layer can absorb and attenuate a spatially incident electromagnetic signal, to reduce or eliminate a reflected electromagnetic signal, and help reduce interference caused by an unwanted electromagnetic signal.

In a possible implementation, there is an avoidance hole between the shielding cover and the shielding frame. The circuit board passes through the avoidance hole.

In a possible implementation, an outer surface of the shielding cover is provided with an insulating layer.

The insulating layer disposed on the shielding cover may help maintain a good insulation and isolation state between the shielding cover and another conductive structural member. If the shielding cover is not provided with the insulating layer, there is a case in which the shielding cover is electrically connected to another conductive structural member. If there is poor contact between the shielding cover and another conductive structural member, there is a possibility that a passive inter-modulation (Passive Inter-Modulation, PIM) problem and a spurious emission (RSE) problem are generated between the shielding cover and the another conductive structural member. The outer surface of the shielding cover in this application is provided with the insulating layer, so that a possibility of the foregoing problem can be effectively reduced.

In a possible implementation, the electronic device further includes an electronic element, the electronic element is disposed on the mainboard, the electronic element is disposed in the accommodating space, and the electronic element is spaced apart from the first connection terminal.

The shielding member may have a shielding effect on the electronic element. Therefore, when the electronic element is in a working state, an electromagnetic signal transmitted by the electronic element is not easily propagated to a component that is located on an outer side of the shielding member and that is relatively close to the electronic element. This effectively reduces a possibility that the electronic element causes signal interference to a neighboring component.

In a possible implementation, the electronic device further includes a housing and an antenna. The mainboard is disposed in the housing. The housing includes a frame. The antenna is disposed on the frame. The first connection terminal, the second connection terminal, and the shielding member are disposed close to the antenna.

The shielding member may provide effective shielding for the first connection terminal and the second connection terminal. Therefore, when the antenna is in a working state of radiating a wireless signal, an electromagnetic signal generated by the antenna does not easily interfere with the first connection terminal and the second connection terminal, thereby reducing a possibility that the antenna adversely affects the camera apparatus when the camera apparatus performs a shooting function.

A second aspect of this application provides a shielding member, applied to an electronic device. The shielding member includes a shielding frame and a shielding cover. The shielding cover is connected to the shielding frame. The shielding cover is connected to the shielding frame to form an accommodating cavity. The accommodating cavity has an opening. The shielding frame is used for grounding. The shielding cover is electrically connected to the shielding frame.

A third aspect of this application provides an electronic device, where the electronic device includes a mainboard, a camera apparatus, and a shielding member.

The mainboard includes a first connection terminal and a ground terminal. The camera apparatus includes a camera module, a circuit board, and a second connection terminal. The camera module is electrically connected to the circuit board. The second connection terminal is disposed on the circuit board. The first connection terminal is electrically connected to the second connection terminal. The shielding member is of an integrally formed structure. The shielding member is connected to the mainboard. Accommodating space is formed between the shielding member and the mainboard. The first connection terminal and the second connection terminal are located in the accommodating space. The shielding member is electrically connected to the ground terminal. The second connection terminal is electrically connected to the shielding member.

In a possible implementation, the shielding member includes a top wall and a side wall. The side wall is of an annular structure. The side wall is connected to the mainboard. The side wall is electrically connected to the ground terminal of the mainboard. The top wall is electrically connected to the second connection terminal.

The side wall of the shielding member is disposed around the first connection terminal. Therefore, in any direction, the shielding member can have a good shielding effect on the first connection terminal.

In a possible implementation, a surface that is of the second connection terminal and that faces away from the first connection terminal is bonded to the top wall of the shielding member by using a conductive adhesive, so that the second connection terminal is electrically connected to the top wall of the shielding member.

In a possible implementation, the electronic device further includes a reinforcement member. The reinforcement member is disposed on a side that is of the second connection terminal and that faces away from the first connection terminal. The reinforcement member is of a conductive structure. The reinforcement member is electrically connected to the second connection terminal. The reinforcement member is electrically connected to the top wall of the shielding member.

The reinforcement member may provide protection for the second connection terminal, to effectively avoid a case in which structural damage occurs in the second connection terminal because the second connection terminal is impacted by an external force. The shielding member may apply compressive stress to the reinforcement member toward the second connection terminal, to ensure connection reliability and stability between the first connection terminal and the second connection terminal, and reduce a possibility that the second connection terminal is removed from the first connection terminal and is in a disconnected state.

In a possible implementation, the top wall of the shielding member directly abuts against the reinforcement member.

The top wall of the shielding member is in direct contact with the reinforcement member to implement electrical connection, so that there is no need to dispose an additional structural member for implementing electrical connection between the shielding member and the reinforcement member. This helps reduce a quantity of used parts and assembly operations.

In a possible implementation, the electronic device further includes a conductive member. The conductive member is disposed between the top wall of the shielding member and the reinforcement member. The conductive member electrically connects the top wall of the shielding member and reinforcement member.

The shielding member and the reinforcement member may jointly press against the conductive member, to ensure good contact between the conductive member and each of the shielding member and the reinforcement member, and maintain stability of an electrical connection state between the conductive member and each of the shielding member and the reinforcement member.

In a possible implementation, the conductive member is of a flexible structure.

The conductive member may be compressed and deformed. Therefore, when a surface of at least one of the shielding member and the reinforcement member is uneven, the conductive member may perform compensation through deformation thereof, to ensure that a close fitted and contact state is maintained between the shielding member and the conductive member and between the reinforcement member and the conductive member. In this way, a good electrical connection state is maintained between the shielding member and the reinforcement member, to help reduce impedance.

In a possible implementation, the reinforcement member is capacitively coupled to the top wall of the shielding member.

The reinforcement member is not in direct contact with the shielding member, so that a case in which poor contact occurs between the shielding member and the reinforcement member can be avoided, thereby reducing a possibility that a passive inter-modulation (Passive Inter-Modulation, PIM) problem and a spurious emission (RSE) problem are generated due to poor contact.

In a possible implementation, the electronic device further includes a high dielectric layer. The high dielectric layer is disposed between the reinforcement member and the top wall of the shielding member.

Each of the shielding member and the reinforcement member is in non-electrical contact with the high dielectric layer. There is no problem of poor contact in a capacitive coupling manner. Therefore, there is no requirement on stability of contact resistance between the high dielectric layer and each of the shielding member and the reinforcement member. In this way, surface processing such as nickel plating and gold plating does not need to be performed on the shielding member and the reinforcement member. In addition, a location for disposing the high dielectric layer can be freely and flexibly selected based on a design requirement.

In a possible implementation, the shielding member has an avoidance hole. The circuit board passes through the avoidance hole.

In a possible implementation, an outer surface of the shielding member is provided with an insulating layer.

The insulating layer disposed on the shielding member may help maintain a good insulation and isolation state between the shielding member and another conductive structural member. If the shielding member is not provided with the insulating layer, there is a case in which the shielding member is electrically connected to another conductive structural member. If there is poor contact between the shielding member and another conductive structural member, there is a possibility that a passive inter-modulation (Passive Inter-Modulation, PIM) problem and a spurious emission (RSE) problem are generated between the shielding member and the another conductive structural member. The outer surface of the shielding member in this application is provided with the insulating layer, so that a possibility of the foregoing problem can be effectively reduced.

### BRIEF DESCRIPTION OF DRAWINGS

FIG. 1 is a schematic diagram of a structure of an electronic device according to this application;
FIG. 2 is a schematic diagram of a partial decomposition structure of an electronic device according to this application;
FIG. 3 is a schematic diagram of a partial structure of a camera apparatus according to this application;
FIG. 4 is a schematic diagram of a partial cross-sectional structure of an electronic device according to a related technology;
FIG. 5 is a schematic diagram of a partial structure of an electronic device according to this application;
FIG. 6 is a schematic diagram of a partial decomposition structure of an electronic device according to this application;
FIG. 7 is a schematic diagram of a partial structure of an electronic device according to this application;
FIG. 8 is a schematic diagram of a partial cross-sectional structure of an electronic device according to this application;
FIG. 9 is a schematic diagram of a partial structure of an electronic device according to this application;
FIG. 10 is a schematic diagram of a partial structure of an electronic device according to this application;
FIG. 11 is a schematic diagram of a partial cross-sectional structure of an electronic device according to this application;
FIG. 12 is a schematic enlarged view of a location M in FIG. 11;
FIG. 13 is a schematic diagram of a partial cross-sectional structure of an electronic device according to this application;
FIG. 14 is a schematic diagram of a partial cross-sectional structure of an electronic device according to this application;
FIG. 15 is a schematic diagram of a partial cross-sectional structure of an electronic device according to this application;
FIG. 16 is a schematic diagram of a partial structure of an electronic device according to this application;
FIG. 17 is a schematic diagram of a partial structure of an electronic device according to this application; and
FIG. 18 is a schematic diagram of a partial structure of an electronic device according to this application.

### Reference numerals:

10. electronic device;
20. display assembly;
30. housing; 31. rear cover; 32. frame;
40. mainboard; 41. first connection terminal; 42. ground terminal;
50. electronic component;
60. camera apparatus; 61. camera module; 611. optical imaging system; 612. image sensor; 62. circuit board; 63. second connection terminal;
70. shielding member;
71. shielding frame; 71a. intermediate through hole; 711. bottom flange; 712. first side plate; 7121. first outer side surface; 7122. second outer side surface; 7123. third outer side surface; 7124. fourth outer side surface; 713. top flange;
72. shielding cover; 721. top plate; 722. second side plate;
70a. top wall;
70b. side wall;
80. snap-in part;
90. fitting part;
100. reinforcement member;
110. conductive member;
120. high dielectric layer;
130. avoidance hole;
140. insulating layer;
150. electronic element;
160. antenna;
170. system on chip;
180. accommodating space;
190. connector;
200. metal bracket;
Z. thickness direction.

### DESCRIPTION OF EMBODIMENTS

An electronic device in the embodiments of this application may be referred to as user equipment (user equipment, UE), a terminal (terminal), or the like. For example, the electronic device may be a mobile terminal or a fixed terminal such as a tablet computer (portable android device, PAD), personal digital processing (personal digital assistant, PDA), a handheld device with a wireless communication function, a computing device, a vehicle-mounted device, a wearable device, a virtual reality (virtual reality, VR) terminal device, an augmented reality (augmented reality, AR) terminal device, a wireless terminal in industrial control (industrial control), a wireless terminal in self-driving (self driving), a wireless terminal in remote medical (remote medical), a wireless terminal in a smart grid (smart grid), a wireless terminal in transportation safety (transportation safety), a wireless terminal in a smart city (smart city), or a wireless terminal in a smart home (smart home). A form of the terminal device is not specifically limited in the embodiments of this application.

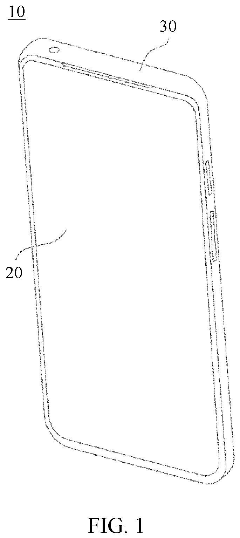

In an embodiment of this application, FIG. 1 schematically shows a structure of an electronic device 10. As shown in FIG. 1, an example in which the electronic device 10 is a handheld device with a wireless communication function is used for description. For example, the handheld device with a wireless communication function may be a mobile phone.

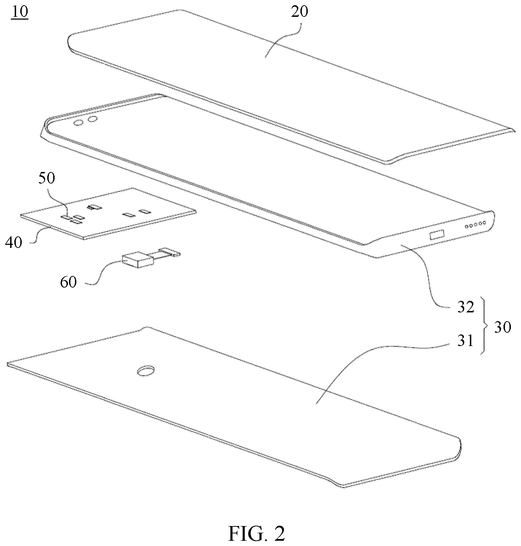

FIG. 2 schematically shows a partial decomposition structure of the electronic device 10. As shown in FIG. 1 and FIG. 2, the electronic device 10 in this embodiment of this application includes a display assembly 20, a housing 30, a mainboard 40, and an electronic component 50.

The display assembly 20 has a display region used to display image information. The display assembly 20 presents image information to a user by using the display region. The display assembly 20 is mounted on the housing 30.

The mainboard 40 may be connected to the housing 30, and is located in the housing 30. The mainboard 40 may be located between the display assembly 20 and the housing 30, so that the user does not easily observe the mainboard 40 from the exterior of the electronic device 10. For example, the housing 30 includes a rear cover 31 and a frame 32. The rear cover 31 is connected to the frame 32. For example, the frame 32 may be but is not limited to a rectangular frame. The mainboard 40 may be disposed in space formed by the rear cover 31 and the frame 32.

The electronic component 50 is disposed on the mainboard 40. The mainboard 40 may be a printed circuit board (Printed Circuit Board, PCB). The electronic component 50 is welded to the mainboard 40 by using a welding process. The electronic component 50 includes but is not limited to a radio frequency chip (Radio Frequency Integrated Circuit, RFIC), a radio frequency power amplifier (Radio Frequency Power Amplifier, RFPA), a wireless fidelity (Wireless Fidelity, WIFI) chip, a central processing unit (Central Processing Unit, CPU), an intelligent algorithm chip, a power management chip (Power Management IC, PMIC), or an application processor (Application Processor, AP). For example, the application processor may be used to carry a system on chip (System On Chip, SOC). The system on chip includes an image signal processing (Image Signal Processing, ISP) module. Because internal space of the electronic device 10 is relatively small, the electronic component 50 is highly integrated on the mainboard 40 to sufficiently reduce a volume of the mainboard 40 and reduce space occupation of the mainboard 40.

The electronic device 10 may further include another component such as a battery. The battery may be disposed in the housing 30. The battery is a structural member that can convert chemical energy into electrical energy. The battery is used to provide electrical energy to the electronic device 10 to ensure normal working of the electronic device 10. For example, the battery may provide electrical energy to the display assembly 20, so that the display assembly 20 displays image information or completes corresponding operation instructions. Alternatively, the battery may provide electrical energy to the mainboard 40, to ensure that the electronic component 50 on the mainboard 40 works normally. For example, the battery may be a lithium ion battery, such as a lithium iron phosphate battery.

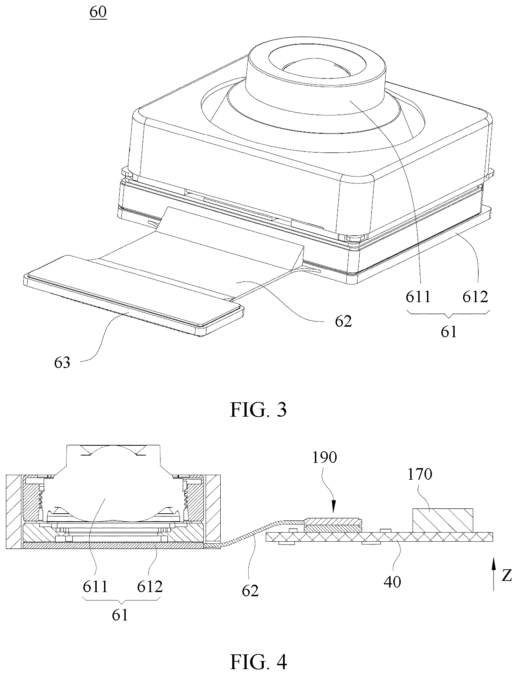

FIG. 3 schematically shows a partial structure of a camera apparatus. As shown in FIG. 2 and FIG. 3, the electronic device 10 may include a camera apparatus 60. The camera apparatus 60 may include a camera module 61 and a circuit board 62. The camera module 61 may be electrically connected to the mainboard 40 by using the circuit board 62, to implement signal interaction. For example, the circuit board 62 may be but is not limited to a flexible printed circuit board (Flexible Printed Circuit Board, FPCB). The camera module 61 of the camera apparatus 60 may be disposed in the housing 30. The housing 30 has a light-transmitting hole. In an axial direction of the light-transmitting hole, a light entry part of the camera module 61 corresponds to the light-transmitting hole. External light may reach the light entry part through the light-transmitting hole. For example, a cross-sectional shape of the light-transmitting hole may be a circle, an ellipse, or a polygon. This is not limited in this application. The camera apparatus 60 may be a rear-facing camera, or may be a front-facing camera. This is not limited in this application.

The camera module 61 may include an optical imaging system 611 and an image sensor 612. The optical imaging system 611 may include a plurality of lenses. When the camera module 61 is used for shooting, light on an object side may be incident on a photosensitive surface of the image sensor 612 after passing through the optical imaging system 611. The photosensitive surface of the image sensor 612 is a surface on which light is received. The optical imaging system 611 has a virtual imaging plane. The imaging plane of the optical imaging system 611 may coincide with the photosensitive surface of the image sensor 612. The image sensor 612 may be a sensor that converts, into an electrical signal, an optical signal that is to be incident on the photosensitive surface. For example, the image sensor 612 may be a complementary metal-oxide-semiconductor (Complementary Metal Oxide Semiconductor, CMOS) sensor or a charge coupled device (Charge coupled Device, CCD).

In a related technology, FIG. 4 schematically shows a partial cross-sectional structure of an electronic device in the related technology. As shown in FIG. 4, the image sensor 612 of the camera module 61 may be electrically connected to a system on chip 170 on the mainboard 40 by using the circuit board 62 and a connector 190. The connector 190 includes two connection terminals that are plug-connected to each other. For example, the connector 190 may be a board-to-board connector (Board-to-board Connectors). When the camera apparatus 60 of the electronic device 10 performs a shooting function, interaction of a signal such as a data signal or a control signal exists between the image sensor 612, the circuit board 62, the connector 190, a wire on the mainboard 40, and an image signal processing module of the system on chip 170. However, because the connector 190 has relatively large ground impedance, the connector 190 becomes an impedance discontinuity point with a sudden change in impedance. As a result, the connector 190 is easily coupled to an external electromagnetic field, resulting in interference with a data signal or a control signal that is transmitted between the camera module 61 and the image signal processing module. Consequently, the camera apparatus 60 is interfered with by a signal, and a phenomenon such as a screen artifact, stalling, or screen freezing occurs in a shooting interface. This affects shooting experience of the electronic device 10. For example, when the radio frequency chip or the wireless fidelity chip transmits power, a generated electromagnetic signal causes signal interference to the connector 190.

According to the electronic device 10 provided in this embodiment of this application, a shielding member is disposed on the mainboard 40, and covers the exterior of a first connection terminal and a second connection terminal. The first connection terminal and the second connection terminal may be grounded by using the shielding member, thereby effectively reducing impedance. In addition, the shielding member may be used to shield the first connection terminal and the second connection terminal. Therefore, according to the electronic device 10 in this embodiment of this application, a possibility that an electromagnetic signal interferes with the first connection terminal and the second connection terminal can be reduced, thereby helping reduce a possibility that the camera apparatus 60 is interfered with by a signal, and improving shooting experience of the electronic device 10.

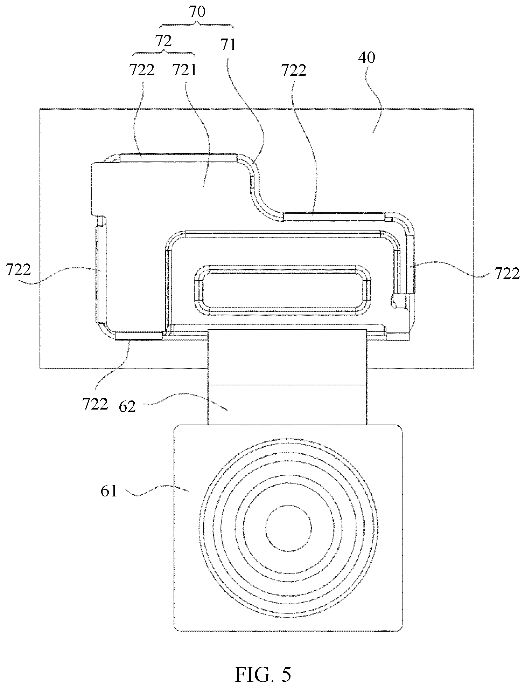

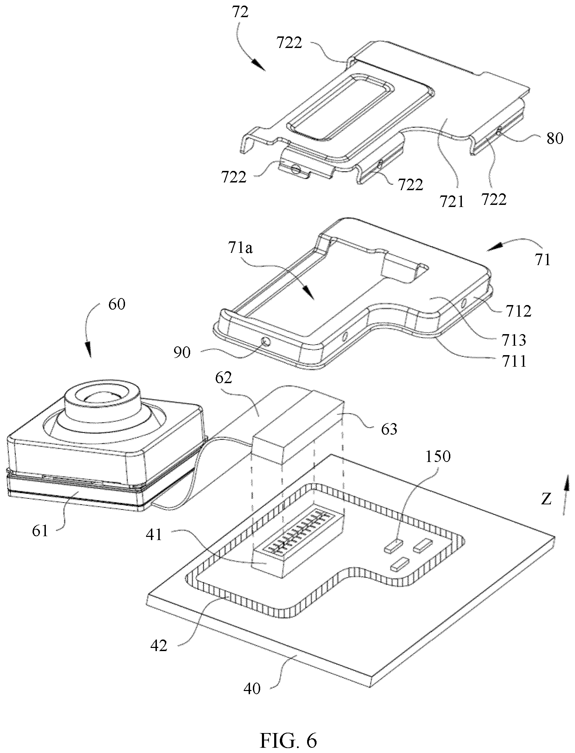

FIG. 5 schematically shows a partial structure of the electronic device. FIG. 5 shows a top-view structure in a thickness direction Z of the mainboard 40 in FIG. 4. FIG. 6 schematically shows a partial decomposition structure of the electronic device 10. As shown in FIG. 5 and FIG. 6, the mainboard 40 in this embodiment of this application includes a first connection terminal 41 and a ground terminal 42. The first connection terminal 41 provides an adapter interface. The first connection terminal 41 may be electrically connected to the system on chip 170 on the mainboard 40. The ground terminal 42 is used for grounding.

The camera apparatus 60 includes the camera module 61, the circuit board 62, and a second connection terminal 63. The camera module 61 is electrically connected to the circuit board 62. The second connection terminal 63 is disposed on the circuit board 62. The second connection terminal 63 is electrically connected to the circuit board 62. For example, the circuit board 62 may be a flexible printed circuit board. For example, the circuit board 62 may be of a strip-shaped structure. The camera module 61 is electrically connected to one end of the circuit board 62, and the second connection terminal 63 is electrically connected to the other end of the circuit board 62. The first connection terminal 41 is electrically connected to the second connection terminal 63. The first connection terminal 41 and the second connection terminal 63 are detachably connected to facilitate assembly or separation of the first connection terminal 41 and the second connection terminal 63, thereby facilitating assembly or separation of the camera apparatus 60 and the mainboard 40. The first connection terminal 41 is connected to the second connection terminal 63 to form a connector. For example, the connector formed by the first connection terminal 41 and the second connection terminal 63 may be a board-to-board connector. The first connection terminal 41 and the second connection terminal 63 may be connected to each other in a plug-connected manner. For example, the first connection terminal 41 and the second connection terminal 63 each have a pin, and the two connection terminals are plug-connected to each other by using respective pins (PIN pin), to implement electrical connection. The camera module 61 may be communicatively connected to the mainboard 40 by using the circuit board 62, the second connection terminal 63, and the first connection terminal 41, to implement interaction of a signal such as a data signal or a control signal.

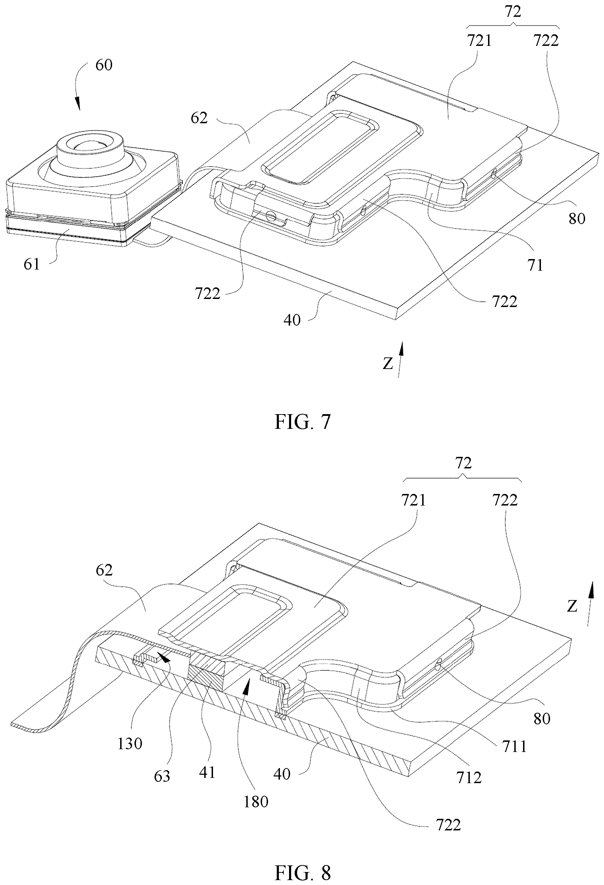

As shown in FIG. 5 and FIG. 6, the electronic device 10 further includes a shielding member 70. The mainboard 40 may provide a mounting base for the shielding member 70. The shielding member 70 is connected to the mainboard 40. The shielding member 70 may be disposed to avoid the electronic component 50 on the mainboard 40. Accommodating space 180 (as shown in FIG. 8) is formed between the shielding member 70 and the mainboard 40. The first connection terminal 41 and the second connection terminal 63 are located in the accommodating space 180. The shielding member 70 is electrically connected to the ground terminal 42 of the mainboard 40, so that the shielding member 70 is grounded.

FIG. 7 schematically shows a partial structure of the electronic device. FIG. 8 schematically shows a partial cross-sectional structure of the electronic device. As shown in FIG. 6, FIG. 7, and FIG. 8, the shielding member 70 includes a shielding frame 71 and a shielding cover 72 that are electrically connected. The shielding frame 71 is used for grounding. The shielding frame 71 is connected to the mainboard 40. The shielding frame 71 is electrically connected to the ground terminal 42 of the mainboard 40. The shielding cover 72 is connected to the shielding frame 71. For example, the shielding cover 72 and the shielding frame 71 are detachably connected. The shielding cover 72 is connected to the shielding frame 71 to form an accommodating cavity having an opening. After the shielding cover 72 is assembled with the shielding frame 71, the shielding member 70 having an accommodating cavity is formed. The second connection terminal 63 is electrically connected to the shielding cover 72.

In this application, the shielding frame 71 is electrically connected to the shielding cover 72, and the shielding frame 71 is electrically connected to the ground terminal 42. Therefore, the shielding cover 72 is indirectly grounded by using the shielding frame 71, and the second connection terminal 63 is indirectly grounded by using the shielding cover 72 and the shielding frame 71. The assembled shielding member 70 may cover the first connection terminal 41 and the second connection terminal 63, and the shielding member 70 is grounded. This helps eliminate parasitic capacitance formed between the ground terminal 42 of the mainboard 40 and the connector formed by the first connection terminal 41 and the second connection terminal 63, thereby helping reduce a possibility that an electromagnetic signal causes electromagnetic coupling interference to the first connection terminal 41 and the second connection terminal 63.

The shielding member 70 is disposed on a periphery of the connector formed by the first connection terminal 41 and the second connection terminal 63. The shielding member 70 covers the connector formed by the first connection terminal 41 and the second connection terminal 63. The accommodating space 180 formed by connecting the shielding member 70 and the mainboard 40 may also be referred to as shielding space. The opening of the accommodating cavity of the shielding member 70 faces the mainboard 40. The accommodating space 180 includes the accommodating cavity of the shielding member 70. The first connection terminal 41 and the second connection terminal 63 are located in the shielding space. The shielding member 70 may be used to provide effective shielding for the first connection terminal 41 and the second connection terminal 63, to reduce an electromagnetic signal of another component on the outer side of the shielding member 70 or an electromagnetic signal in an environment in which the electronic device 10 is located from interfering with the first connection terminal 41 and the second connection terminal 63. This helps reduce a possibility that signal interaction between the camera module 61 and the mainboard 40 is interfered with because the first connection terminal 41 and the second connection terminal 63 are interfered with by an electromagnetic signal, thereby improving working stability of the camera apparatus 60.

In the electronic device 10 of this application, the mainboard 40 includes the first connection terminal 41 and the ground terminal 42, and the camera apparatus 60 includes the camera module 61, the circuit board 62, and the second connection terminal 63. The first connection terminal 41 and the second connection terminal 63 are detachably connected. The first connection terminal 41 is electrically connected to the second connection terminal 63. The camera apparatus 60 is communicatively connected to the mainboard 40, to implement signal interaction. The shielding member 70 is connected to the mainboard 40, and the shielding member 70 covers the exterior of the first connection terminal 41 and the second connection terminal 63. The shielding member 70 is electrically connected to the ground terminal 42 of the mainboard 40, to implement grounding. The second connection terminal 63 is electrically connected to the shielding member 70. Therefore, the first connection terminal 41, the second connection terminal 63, the shielding cover 72, and the shielding frame 71 may be grounded by using the ground terminal 42 of the mainboard 40. This helps reduce ground impedance at the connector formed by the first connection terminal 41 and the second connection terminal 63, to avoid a sudden change in impedance at the connector formed by the first connection terminal 41 and the second connection terminal 63, and helps eliminate the parasitic capacitance formed between the ground terminal 42 of the mainboard 40 and the connector formed by the first connection terminal 41 and the second connection terminal 63, thereby helping reduce a possibility that an electromagnetic signal interferes with the first connection terminal 41 and the second connection terminal 63 and electromagnetic coupling occurs. Therefore, it is ensured that a signal transmission process between the camera apparatus 60 and the mainboard 40 is stable, so that the electronic device 10 can smoothly perform a shooting function, thereby improving shooting experience. The shielding member 70 may also effectively shield the electromagnetic signal from adversely affecting and interfering with the first connection terminal 41 and the second connection terminal 63, thereby further helping reduce a possibility that an interaction signal between the camera apparatus 60 and the mainboard 40 is interfered with.

In some implementable manners, in the shielding member 70 in this application, the shielding cover 72 and the shielding frame 71 may be welded to each other, to ensure good connection reliability and stability between the shielding cover 72 and the shielding frame 71, and reduce a possibility that the shielding cover 72 and the shielding frame 71 are separated from each other due to accidental collision of the shielding cover 72.

In some implementable manners, in the shielding member 70 of this application, the shielding cover 72 and the shielding frame 71 are detachably connected, to facilitate assembly or separation of the shielding cover 72 and the shielding frame 71. The first connection terminal 41 and the second connection terminal 63 are disposed between the shielding cover 72 and the mainboard 40. When repair or check needs to be performed on the first connection terminal 41 and the second connection terminal 63, the shielding cover 72 is removed from the shielding frame 71, without a need to remove the shielding member 70 as a whole from the mainboard 40. After the first connection terminal 41 and the second connection terminal 63 are repaired or checked, the shielding cover 72 is reassembled with the shielding frame 71. Therefore, a manner in which the shielding cover 72 and the shielding frame 71 are detachably connected helps improve repair or check working efficiency. An assembly process may be but is not limited to the following process: disposing the first connection terminal 41 on the mainboard 40; then sleeving a periphery of the first connection terminal 41 by using the shielding frame 71; then connecting the shielding frame 71 to the mainboard 40; connecting the second connection terminal 63 to the first connection terminal 41; connecting the shielding cover 72 to the shielding frame 71; and covering the first connection terminal 41 and the second connection terminal 63 by using the assembled shielding member 70.

In some implementable manners, the shielding member 70 may be welded to the mainboard 40 by using the welding process. The shielding member 70 is welded to the ground terminal 42. This helps implement good grounding, and can ensure that connection strength between the shielding member 70 and the ground terminal 42 is relatively large, thereby improving connection stability between the shielding member 70 and the ground terminal 42. For example, the shielding member 70 and the ground terminal 42 may be welded by using solder. Specifically, the shielding frame 71 of the shielding member 70 is welded to the mainboard 40 by using the welding process. The shielding frame 71 of the shielding member 70 may be welded to the ground terminal 42.

In some implementable manners, materials of both the shielding cover 72 and the shielding frame 71 may be conductive metal materials. For example, the materials of the shielding cover 72 and the shielding frame 71 may be stainless steel.

In some implementable manners, as shown in FIG. 6, the electronic device 10 further includes an electronic element 150. The electronic element 150 is disposed on the mainboard 40. The electronic element 150 is disposed in the accommodating space 180. The electronic element 150 is spaced apart from the first connection terminal 41. The shielding member 70 may have a shielding effect on the electronic element 150. Therefore, when the electronic element 150 is in a working state, an electromagnetic signal transmitted by the electronic element 150 is not easily propagated to a component that is located on an outer side of the shielding member 70 and that is relatively close to the electronic element 150. This effectively reduces a possibility that the electronic element 150 causes signal interference to a neighboring component. In some examples, the electronic element 150 may be an inductor. The electronic device 10 further includes an antenna. The housing 30 includes a rear cover 31 and a frame 32. The antenna may be disposed on the frame 32. When the first connection terminal 41 and the shielding member 70 are disposed in an edge region that is on the mainboard 40 and that is close to the antenna, the electronic element 150 (for example, the inductor) near the first connection terminal 41 is relatively close to the antenna. In this embodiment of this application, because the inductor is shielded by the shielding member 70, when in a working state, the inductor does not easily causes signal interference to a neighboring antenna.

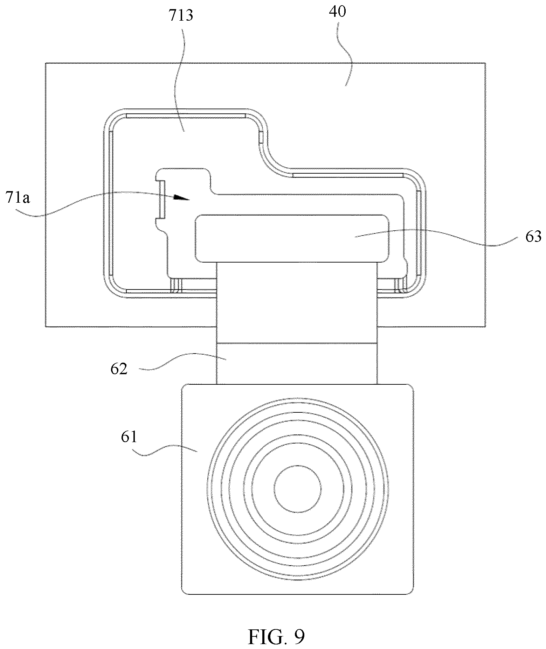

In some implementable manners, FIG. 9 schematically shows a partial structure of the electronic device. As shown in FIG. 6 and FIG. 9, the shielding frame 71 may be a frame having an intermediate through hole 71a. The first connection terminal 41 is located in the intermediate through hole 71a. In some examples, the shielding frame 71 may be an annular frame. A shape of an orthographic projection of the shielding frame 71 on the mainboard 40 may be regular, such as a rectangle or a circle. A shape of an orthographic projection of the shielding frame 71 on the mainboard 40 may alternatively be irregular. This is not specifically limited in this application. In some examples, the shielding frame 71 may also have a notch, and the shielding frame 71 is disconnected and discontinuous at the notch, so that the shielding frame 71 is not of a continuous annular structure.

The first connection terminal 41 is located in the shielding frame 71. For example, there is a distance between the first connection terminal 41 and the shielding frame 71. In the thickness direction Z of the mainboard 40, an orthographic projection of the first connection terminal 41 is located in an orthographic projection of the shielding frame 71, and the two orthographic projections do not overlap. The intermediate through hole 71a of the shielding frame 71 avoids the first connection terminal 41. Therefore, in a process of assembling the second connection terminal 63 with the first connection terminal 41, location interference between the shielding frame 71 and the second connection terminal 63 is avoided. In some examples, the shielding frame 71 may be an annular frame. The shielding frame 71 is disposed around the first connection terminal 41. Therefore, in any direction, the shielding frame 71 can have a good shielding effect on the first connection terminal 41.

In some implementable manners, as shown in FIG. 6, FIG. 7, and FIG. 8, the shielding frame 71 includes a bottom flange 711, a first side plate 712, and a top flange 713. Both the bottom flange 711 and the top flange 713 are connected to the first side plate 712. The bottom flange 711 and the top flange 713 separately intersect with the first side plate 712. The bottom flange 711 is electrically connected to the ground terminal 42 of the mainboard 40. For example, the bottom flange 711 may be welded to the ground terminal 42 of the mainboard 40. For example, the bottom flange 711 is of an annular structure, and a shape of the ground terminal 42 of the mainboard 40 may match the bottom flange 711, that is, the ground terminal 42 may also be of an annular structure. For example, a material of the ground terminal 42 may be but is not limited to copper or a copper alloy.

An outer surface that is of the top flange 713 and that faces away from the mainboard 40 is electrically connected to an inner surface that is of the shielding cover 72 and that faces the mainboard 40. This helps implement a relatively large electrical connection area between the shielding cover 72 and the shielding frame 71, to effectively reduce impedance, so that a good electrical connection state is maintained between the shielding cover 72 and the shielding frame 71. The shielding cover 72 may be grounded to the ground terminal 42 of the mainboard 40 by using the top flange 713, the first side plate 712, and the bottom flange 711. In some examples, the outer surface that is of the top flange 713 and that faces away from the mainboard 40 directly abuts against the inner surface that is of the shielding cover 72 and that faces the mainboard 40, so that the top flange 713 is electrically connected to the shielding cover 72.

In some examples, in the thickness direction Z of the mainboard 40, the bottom flange 711 and the top flange 713 are respectively disposed at a bottom end and a top end of the first side plate 712. The bottom flange 711 and the top flange 713 are respectively located on two sides of the first side plate 712. The bottom flange 711 may be folded outward by facing away from the first connection terminal 41, and the top flange 713 may be folded inward toward the first connection terminal 41. In the thickness direction Z of the mainboard 40, an orthographic projection of the top flange 713 does not overlap an orthographic projection of the first connection terminal 41.

In some examples, as shown in FIG. 6 and FIG. 8, the outer surface that is of the top flange 713 and that faces away from the mainboard 40 directly abuts against the inner surface that is of the shielding cover 72 and that faces the mainboard 40, so that the top flange 713 is electrically connected to the shielding cover 72. As shown in FIG. 6 and FIG. 9, a width of at least a part of the top flange 713 is greater than a width of the bottom flange 711. The width of the top flange 713 and the width of the bottom flange 711 refer to sizes measured in a direction perpendicular to the thickness direction Z of the mainboard 40. After the shielding cover 72 and the shielding frame 71 are processed and manufactured, there is a possibility of surface unevenness. Therefore, if surfaces that are of the shielding cover 72 and the shielding frame 71 and that are used for contact are uneven, an actual contact area between the shielding cover 72 and the shielding frame 71 is reduced. This does not help maintain good electrical connection between the shielding cover 72 and the shielding frame 71. In this application, a manner of setting the width of at least a part of the top flange 713 to be relatively large helps increase a contact area between the shielding cover 72 and the shielding frame 71, to effectively compensate for the contact area between the shielding cover 72 and the shielding frame 71, and reduce a possibility that the contact area does not meet a requirement because the surfaces that are of the shielding cover 72 and the shielding frame 71 and that are used for contact are uneven.

The bottom flange 711 is set to have a relatively small width. This can help reduce an orthographic projection area of the bottom flange 711 on the mainboard 40 when connection strength between the bottom flange 711 and the mainboard 40 is met, thereby reducing space occupation of the mainboard 40 by the bottom flange 711, and reducing a possibility that a region that is of the mainboard 40 and in which the electronic component 50 can be disposed is reduced because the bottom flange 711 occupies excessive space on the mainboard 40.

For example, the width of the top flange 713 at any location is greater than the width of the bottom flange 711.

For example, a width of a partial region of the top flange 713 is greater than a width of a remaining region thereof. In a region in which the top flange 713 needs to avoid the first connection terminal 41, the width of the top flange 713 may be set to be relatively small. In a region in which the top flange 713 does not need to avoid the first connection terminal 41, the width of the top flange 713 may be set to be relatively large. Therefore, when there is no location interference between the top flange 713 and the first connection terminal 41, the top flange 713 as a whole may be set to have a relatively large width size, thereby facilitating a relatively large contact area between the shielding cover 72 and the shielding frame 71.

For example, a blank for processing and manufacturing the shielding frame 71 is a flat sheet. First, the blank is stamped by using a stamping process, to obtain the shielding frame 71 with the bottom flange 711, the first side plate 712, and the top flange 713 through stamping. Next, shaping processing is performed on the shielding frame 71 to sufficiently release internal stress of the shielding frame 71.

In some implementable manners, as shown in FIG. 6, FIG. 7, and FIG. 8, the shielding cover 72 and the shielding frame 71 are snap-fitted with each other. The shielding cover 72 and the shielding frame 71 are in contact with and pressed against each other at a snap-fit location, so that good electrical connection can also be maintained between the shielding cover 72 and the shielding frame 71 at the snap-fit location. A snap-in part 80 is disposed on one of the shielding cover 72 and the shielding frame 71, and a fitting part 90 is disposed on the other thereof. The shielding cover 72 and the shielding frame 71 may be snap-fitted with each other by using the snap-in part 80 and the fitting part 90. A snap-fit manner is used for the shielding cover 72 and the shielding frame 71, to facilitate quick assembly or separation of the shielding cover 72 and the shielding frame 71, and improve assembly or separation working efficiency.

The snap-in part 80 and the fitting part 90 that are snap-fitted with each other may be pressed against and fitted with each other, so that good electrical connection can also be maintained between the shielding cover 72 and the shielding frame 71 at a location at which the snap-in part 80 is snap-fitted with the fitting part 90. After the snap-in part 80 is snapped into the fitting part 90, the snap-in part 80 may be limited by the fitting part 90, so that a stable connection state can be maintained between the snap-in part 80 and the fitting part 90. Under an external force, the snap-in part 80 is not easily detached from the fitting part 90, thereby reducing a possibility that a shielding failure of the shielding member 70 is caused because the shielding cover 72 and the shielding frame 71 are separated from each other due to accidental collision.

In some examples, the snap-in part 80 may be a protruding part, and the fitting part 90 may be a blind hole or a through hole.

In some examples, the shielding cover 72 may be of an integrally formed structure. The shielding frame 71 may be of an integrally formed structure. Processing may be directly performed on one of the shielding cover 72 and the shielding frame 71 to form the snap-in part 80, and processing may be directly performed on the other thereof to form the fitting part 90. Therefore, structures of the shielding cover 72 and the shielding frame 71 may maintain good integrity. In addition, an additional snap-fit assembly including the snap-in part 80 and the fitting part 90 does not need to be disposed between the shielding cover 72 and the shielding frame 71. This helps reduce a quantity of used parts, and reduces assembly operations that one of the shielding cover 72 and the shielding frame 71 needs to be assembled with the snap-in part 80 and the other thereof needs to be assembled with the fitting part 90.

In some examples, the outer surface that is of the top flange 713 and that faces away from the mainboard 40 directly abuts against the inner surface that is of the shielding cover 72 and that faces the mainboard 40. In addition, the shielding cover 72 and the shielding frame 71 are snap-fitted with each other, so that connection reliability between the shielding cover 72 and the shielding frame 71 can be improved. Therefore, the shielding cover 72 effectively presses against the top flange 713, to ensure that a good fitted and contact state is maintained between the shielding cover 72 and the top flange 713, and reduces a possibility that poor contact occurs between the shielding cover 72 and the top flange 713 due to loosening of the shielding cover 72 and the shielding frame 71, thereby reducing a possibility that a passive inter-modulation (Passive Inter-Modulation, PIM) problem and a spurious emission (RSE) problem are generated due to poor contact.

In some examples, the shielding frame 71 may include the first side plate 712, the bottom flange 711, and the top flange 713 that are connected to each other. The shielding cover 72 and the first side plate 712 are snap-fitted with each other. A snap-fit manner is used for the shielding cover 72 and the first side plate 712, to facilitate quick assembly or separation of the shielding cover 72 and the shielding frame 71, and improve assembly or separation working efficiency. For example, the snap-in part 80 is disposed on one of the shielding cover 72 and the first side plate 712, and the fitting part 90 is disposed on the other thereof. The snap-in part 80 is snap-fitted with the fitting part 90. The outer surface that is of the top flange 713 of the shielding frame 71 and that faces away from the mainboard 40 is electrically connected to an inner surface that is of a top plate and that faces the mainboard 40.

As shown in FIG. 6, FIG. 7, and FIG. 8, the shielding cover 72 may include a top plate 721 and a second side plate 722 that are connected to each other. The second side plate 722 and the top plate 721 of the shielding cover 72 intersect each other, and there is a predetermined included angle between the second side plate 722 and the top plate 721. For example, the included angle between the second side plate 722 and the top plate 721 may be 90°. There may also be an arc transition segment between the second side plate 722 and the top plate 721 to reduce stress concentration between the second side plate 722 and the top plate 721. For example, a blank for processing and manufacturing the shielding cover 72 is a flat sheet. First, the blank is stamped by using a stamping process, to obtain the shielding cover 72 with the second side plate 722 and the top plate 721 through stamping. Next, shaping processing is performed on the shielding cover 72 to sufficiently release internal stress of the shielding cover 72.

The snap-in part 80 is disposed on one of the first side plate 712 of the shielding frame 71 and the second side plate 722 of the shielding cover 72, and the fitting part 90 is disposed on the other thereof. The first connection terminal 41 and the second connection terminal 63 are disposed between the top plate 721 of the shielding cover 72 and the mainboard 40. The first connection terminal 41 and the second connection terminal 63 are disposed on a side that is of the top plate 721 of the shielding cover 72 and that faces the mainboard 40.

In some examples, in a process of assembling the shielding cover 72 with the shielding frame 71, before the snap-in part 80 is snapped into the fitting part 90, the second side plate 722 of the shielding cover 72 may be elastically deformed. After the snap-in part 80 is snapped into the fitting part 90, the snap-in part 80 and the fitting part 90 are pressed against and fitted with each other under the action of an elastic recovery force of the second side plate 722. In addition, the top flange 713 of the shielding frame 71 and the top plate 721 of the shielding cover 72 are pressed against and fitted with each other.

In some examples, the snap-in part 80 is disposed on the shielding cover 72, and the fitting part 90 is disposed on the shielding frame 71. For example, the fitting part 90 is disposed on the first side plate 712 of the shielding frame 71, and the snap-in part 80 is disposed on the second side plate 722 of the shielding cover 72.

The fitting part 90 on the first side plate 712 of the shielding frame 71 has an opening facing away from the intermediate through hole 71a, that is, the fitting part 90 has an opening disposed outward. The snap-in part 80 on the second side plate 722 of the shielding cover 72 protrudes toward the accommodating space 180. After the shielding cover 72 is assembled with the shielding frame 71, the second side plate 722 of the shielding cover 72 is located on the outer side of the first side plate 712 of the shielding frame 71, and is in an externally visible state. The snap-in part 80 on the second side plate 722 is located in the fitting part 90.

In some examples, after the shielding cover 72 is snap-fitted with the shielding frame 71, the second side plate 722 may abut against the first side plate 712, so that the first side plate 712 is in contact with the second side plate 722.

In some examples, the first side plate 712 of the shielding frame 71 may have a plurality of outer side surfaces. The shielding cover 72 may include a plurality of second side plates 722. The plurality of second side plates 722 are separately independent. There is a distance between two adjacent second side plates 722, so that a gap is formed between two adjacent second side plates 722. The second side plates 722 are disposed independently. Therefore, in a snap-fit process, when any one of the second side plates 722 is deformed, none of the other second side plates 722 is pulled. The snap-in part 80 may be disposed on each second side plate 722. The fitting part 90 is disposed at a location that is on the first side plate 712 and that corresponds to the second side plate 722.

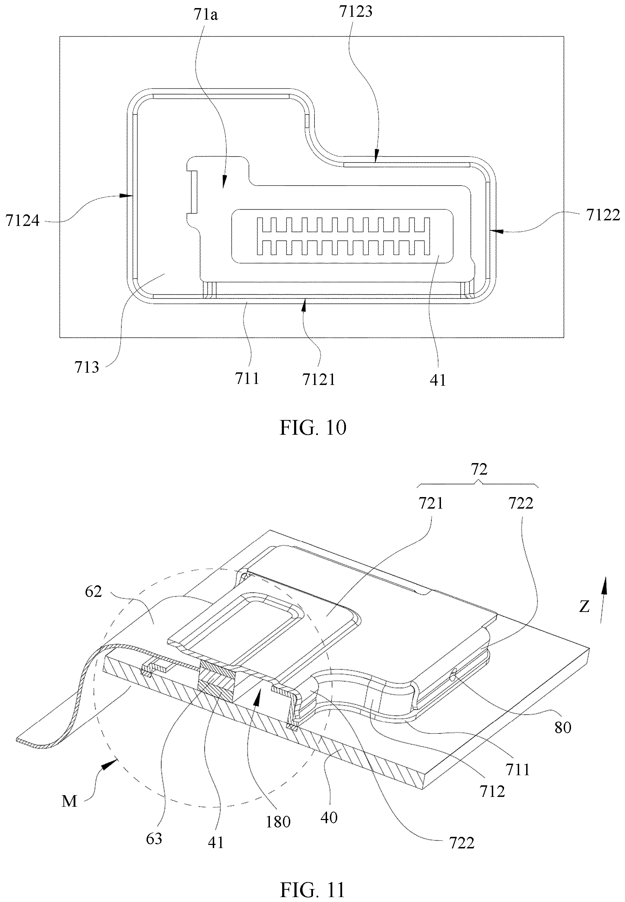

For example, FIG. 10 schematically shows a partial structure of the electronic device. As shown in FIG. 8 to FIG. 10, the first side plate 712 of the shielding frame 71 has a first outer side surface 7121, a second outer side surface 7122, a third outer side surface 7123, and a fourth outer side surface 7124 that are connected to each other. The circuit board 62 of the camera apparatus 60 may pass through between the shielding cover 72 and the shielding frame 71. The circuit board 62 of the camera apparatus 60 corresponds to the first outer side surface 7121. The third outer side surface 7123 may be a stepped surface. The shielding cover 72 may include five second side plates 722. The first outer side surface 7121 corresponds to one second side plate 722, the second side plate 722 is close to the fourth outer side surface 7124, and there is a distance between the second side plate 722 and the circuit board 62 of the camera apparatus 60. The second outer side surface 7122 and the fourth outer side surface 7124 each correspond to one second side plate 722. The third outer side face 7123 corresponds to two second side faces 722. One second side plate 722 close to the second outer side surface 7122 is relatively close to the first outer side surface 7121, and one second side plate 722 close to the fourth outer side surface 7124 is relatively away from the first outer side surface 7121.

In some examples, the outer surface that is of the top flange 713 and that faces away from the mainboard 40 directly abuts against the inner surface that is of the top plate 721 and that faces the mainboard 40, so that the top flange 713 is electrically connected to the top plate 721.

In some implementable manners, one end of the circuit board 62 is connected to the camera module 61, and the other end thereof is provided with the second connection terminal 63. The second connection terminal 63 is disposed on an end part that is of the circuit board 62 and that is away from the camera module 61.

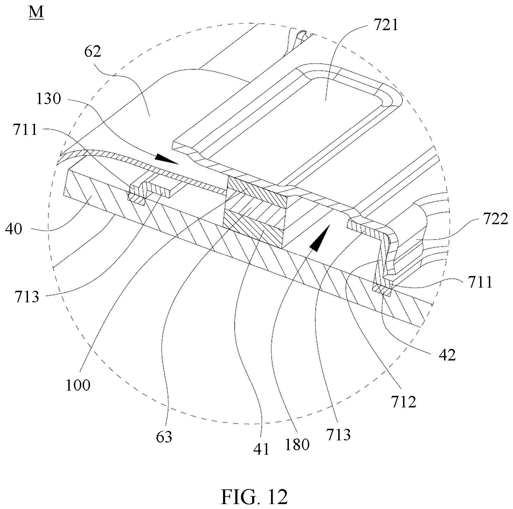

In some examples, FIG. 11 schematically shows a partial cross-sectional structure of the electronic device. FIG. 12 is an enlarged view of a location M in FIG. 11. As shown in FIG. 11 and FIG. 12, the shielding member 70 includes an avoidance hole 130. In some examples, the end part that is of the circuit board 62 and on which the second connection terminal 63 is disposed passes through the avoidance hole 130, and is located within the accommodating space 180 together with the second connection terminal 63. After the shielding cover 72 and the shielding frame 71 are snap-fitted and assembled with each other, the avoidance hole 130 may be formed between the shielding cover 72 and the shielding frame 71. The circuit board 62 of the camera apparatus 60 passes through the avoidance hole 130. After the second connection terminal 63 is connected to the first connection terminal 41, the circuit board 62 is located above the shielding frame 71. For example, the avoidance hole 130 corresponds to the first outer side surface 7121 of the first side plate 712. The circuit board 62 of the camera apparatus 60 corresponds to the first outer side surface 7121 of the first side plate 712.

In some implementable manners, a surface that is of the second connection terminal 63 and that faces away from the first connection terminal 41 is bonded to the shielding cover 72 by using a conductive adhesive, so that the second connection terminal 63 is electrically connected to the shielding cover 72. An assembly manner may be but is not limited to the following: After the second connection terminal 63 is assembled with the first connection terminal 41, the conductive adhesive is disposed on the surface that is of the second connection terminal 63 and that faces away from the first connection terminal 41. Then, the shielding cover 72 is snap-fitted with the shielding frame 71. After the shielding cover 72 is assembled with the shielding frame 71, the shielding cover 72 is bonded to the conductive adhesive.

In some implementable manners, as shown in FIG. 12, the electronic device 10 further includes a reinforcement member 100. The reinforcement member 100 is located in the accommodating space 180. At least a part of the reinforcement member 100 is disposed on a side that is of the second connection terminal 63 and that faces away from the first connection terminal 41. The shielding member 70 may apply compressive stress to the reinforcement member 100 toward the second connection terminal 63, to ensure connection reliability and stability between the first connection terminal 41 and the second connection terminal 63, and reduce a possibility that the second connection terminal 63 is removed from the first connection terminal 41 and is in a disconnected state.

The reinforcement member 100 may provide protection for the second connection terminal 63, to effectively avoid a case in which structural damage occurs in the second connection terminal 63 because the second connection terminal 63 is impacted by an external force. For example, the reinforcement member 100 may isolate the second connection terminal 63 from the shielding member 70, to reduce a possibility that a structure of the second connection terminal 63 is damaged because the shielding member 70 directly applies compressive stress to the second connection terminal 63. For example, the reinforcement member 100 may be connected to the second connection terminal 63.

The reinforcement member 100 is of a conductive structure. The reinforcement member 100 is electrically connected to the second connection terminal 63. The reinforcement member 100 is electrically connected to the shielding cover 72. Therefore, the second connection terminal 63 is electrically connected to the ground terminal 42 of the mainboard 40 by using the reinforcement member 100, the shielding cover 72, and the shielding frame 71, to implement indirect grounding.

In some embodiments, the structure of the shielding member 70 may be replaced by a pressing steel sheet. For example, a strip-shaped pressing steel sheet is disposed above the reinforcement member 100 in the thickness direction Z of the mainboard 40. The pressing steel sheet is used to press the reinforcement member 100 and the second connection terminal 63 in the thickness direction Z of the mainboard 40. Grounding to the mainboard 40 may be implemented by using two end parts of the pressing steel sheet. For example, a fastener such as a screw may be used to connect the end part of the pressing steel sheet to the mainboard 40 to implement grounding. In this solution, a ground region between the pressing steel sheet and the mainboard 40 is relatively small, and a shielding region of the pressing steel sheet for the first connection terminal 41 and the second connection terminal 63 is also relatively small. Compared with the structure of the shielding member 70, a ground region between the shielding member 70 and the mainboard 40 is relatively large, and the shielding member 70 may cover the first connection terminal 41 and the second connection terminal 63, so that the shielding member 70 can effectively improve a shielding effect. In addition, a relatively large contact area between the reinforcement member 100 and the shielding member 70 helps implement a relatively large electrical connection area between the reinforcement member 100 and the shielding member 70 and reduce impedance, so that a manner of disposing both the shielding member 70 and the reinforcement member 100 can effectively improve a shielding effect.

A material of the reinforcement member 100 may be a metal material. For example, the material of the reinforcement member 100 may be steel, for example, may be stainless steel. For example, the reinforcement member 100 may be a steel sheet.

In some examples, at least one of the second connection terminal 63 and the top plate 721 of the shielding cover 72 may be bonded to the reinforcement member 100. For example, the reinforcement member 100 may be connected to the second connection terminal 63 through bonding. For example, the reinforcement member 100 may be bonded to the second connection terminal 63 by using a conductive adhesive layer, to implement electrical connection between the reinforcement member 100 and the second connection terminal 63.

In some examples, the shielding cover 72 of the shielding member 70 directly abuts against the reinforcement member 100. The shielding cover 72 of the shielding member 70 is in direct contact with the reinforcement member 100 to implement electrical connection, so that there is no need to dispose an additional structural member for implementing electrical connection between the shielding member 70 and the reinforcement member 100. This helps reduce a quantity of used parts and assembly operations. The shielding cover 72 is located on a side that is of the reinforcement member 100 and that faces away from the mainboard 40. After the shielding cover 72 is assembled with the shielding frame 71, the shielding cover 72 may directly abut against the reinforcement member 100. The shielding cover 72 may apply compressive stress to the reinforcement member 100 and the second connection terminal 63, to ensure connection stability between the second connection terminal 63 and the first connection terminal 41.

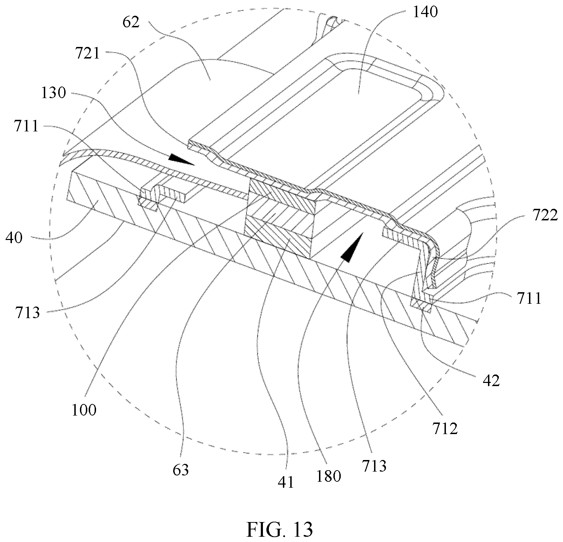

In some examples, FIG. 13 schematically shows a partial cross-sectional structure of the electronic device. As shown in FIG. 13, the shielding member 70 has an insulating layer 140. An outer surface of the shielding cover 72 may be provided with the insulating layer 140. The insulating layer 140 disposed on the shielding cover 72 may help maintain a good insulation and isolation state between the shielding cover 72 and another conductive structural member. If the shielding cover 72 is not provided with the insulating layer 140, there is a case in which the shielding cover 72 is electrically connected to another conductive structural member. If there is poor contact between the shielding cover 72 and another conductive structural member, there is a possibility that a passive inter-modulation (Passive Inter-Modulation, PIM) problem and a spurious emission (RSE) problem are generated between the shielding cover 72 and the another conductive structural member. The outer surface of the shielding cover 72 in this application is provided with the insulating layer 140, so that a possibility of the foregoing problem can be effectively reduced.

For example, the outer surface of the shielding cover 72 may be provided with insulating paint. The insulating paint is cured to form the insulating layer 140. For example, the insulating paint may be sprayed on the outer surface of the shielding cover 72 through spraying.

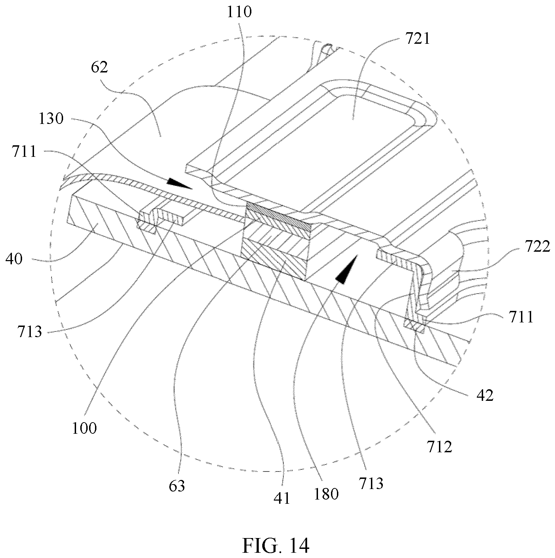

In some examples, FIG. 14 schematically shows a partial cross-sectional structure of the electronic device. As shown in FIG. 13, the electronic device 10 further includes a conductive member 110. The conductive member 110 is disposed between the shielding cover 72 of the shielding member 70 and the reinforcement member 100. The conductive member 110 may implement electrical connection between the shielding member 70 and the reinforcement member 100. After the shielding cover 72 is assembled with the shielding frame 71, the shielding cover 72 and the reinforcement member 100 may jointly press against the conductive member 110, to ensure good contact between the conductive member 110 and each of the shielding member 70 and the reinforcement member 100, and maintain stability of an electrical connection state between the conductive member 110 and each of the shielding member 70 and the reinforcement member 100.

The conductive member 110 may be of a flexible structure, and has compressible and deformable performance. The shielding cover 72 of the shielding member 70 and the reinforcement member 100 may jointly press against the conductive member 110. The conductive member 110 may be compressed and deformed. Therefore, when a surface of at least one of the shielding cover 72 of the shielding member 70 and the reinforcement member 100 is uneven, the conductive member 110 may perform compensation through deformation thereof, to ensure that a close fitted and contact state is maintained between the shielding cover 72 of the shielding member 70 and the conductive member 110 and between the reinforcement member 100 and the conductive member 110. In this way, a good electrical connection state is maintained between the shielding cover 72 of the shielding member 70 and the reinforcement member 100, to help reduce impedance.

For example, the conductive member 110 may be a conductive fabric or a conductive adhesive layer.

In some examples, the reinforcement member 100 is capacitively coupled to the shielding cover 72 of the shielding member 70, thereby implementing an equivalent electrical connection effect between the reinforcement member 100 and the shielding member 70. A capacitor with relatively large capacitance may be equivalently formed between the reinforcement member 100 and the shielding cover 72 of the shielding member 70, so that an electrical signal can be coupled from one of the reinforcement member 100 and the shielding member 70 to the other thereof. The reinforcement member 100 is not in direct contact with the shielding cover 72, so that a case in which poor contact occurs between the shielding cover 72 and the reinforcement member 100 can be avoided, thereby reducing a possibility that a passive inter-modulation (Passive Inter-Modulation, PIM) problem and a spurious emission (RSE) problem are generated due to poor contact.

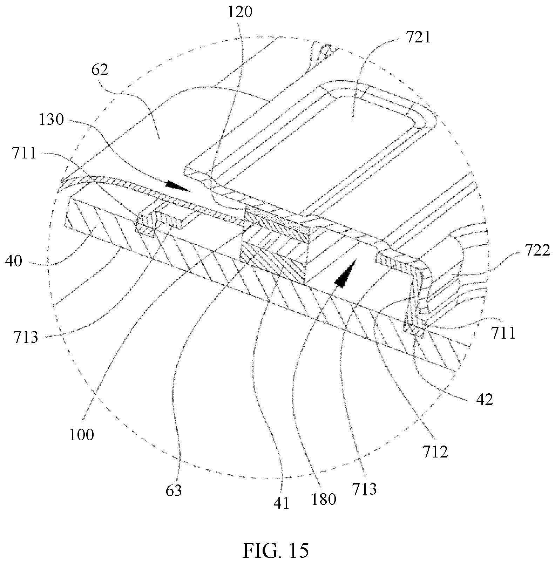

FIG. 15 schematically shows a partial cross-sectional structure of the electronic device. As shown in FIG. 15, the electronic device 10 further includes a high dielectric layer 120. The high dielectric layer 120 is disposed between the shielding cover 72 of the shielding member 70 and the reinforcement member 100. When the shielding member 70, the reinforcement member 100, and the high dielectric layer 120 are assembled, the shielding cover 72 of the shielding member 70 and the reinforcement member 100 may jointly compress the high dielectric layer 120. The shielding member 70, the reinforcement member 100, and the high dielectric layer 120 form a capacitive coupling.

The high dielectric layer 120 is of a membrane structure with a relatively high dielectric constant. The high dielectric layer 120 may be used as an insulating medium, so that the reinforcement member 100 can be isolated from the shielding member 70. The reinforcement member 100 and the shielding cover 72 of the shielding member 70 each form a coupling surface with a corresponding region of the high dielectric layer 120. According to a capacitance calculation formula, when a distance between the reinforcement member 100 and the shielding cover 72 of the shielding member 70 and an area of the coupling surface are unchanged, if a dielectric constant of an insulating medium between the reinforcement member 100 and the shielding cover 72 of the shielding member 70 is larger, capacitance of an equivalently formed capacitor is larger. According to a capacitive impedance calculation formula, larger capacitance of a capacitor indicates smaller capacitive impedance thereof. The capacitive impedance is equivalent impedance.

The shielding member 70 and the reinforcement member 100 each are in non-electrical contact with the high dielectric layer 120. There is no problem of poor contact in the capacitive coupling manner. Therefore, there is no requirement on stability of contact resistance between the high dielectric layer 120 and each of the shielding member 70 and the reinforcement member 100, so that surface processing such as nickel plating and gold plating does not need to be performed on the shielding member 70 and the reinforcement member 100. In addition, a location for disposing the high dielectric layer 120 may be freely and flexibly selected based on a design requirement.

For example, when a high-frequency electrical signal is generated on the reinforcement member 100, the high-frequency electrical signal may be released to the shielding member 70 through capacitive coupling between the reinforcement member 100 and the shielding member 70.

For example, the high dielectric layer 120 may have good elasticity, and therefore can be applied to narrow space. In addition, a resilience capability of the high dielectric layer 120 may be used to absorb an assembly tolerance and a machining tolerance of the shielding member 70 and the reinforcement member 100. This ensures that each of the shielding member 70 and the reinforcement member 100 is in a good pressing state with the high dielectric layer 120.

For example, the high dielectric layer 120 may include an elastomer and a magnesium powder or an aluminum powder that is disposed in the elastomer. A material of the elastomer may be plastic.

For example, the high dielectric layer 120 may include a wave-absorbing material, so that the high dielectric layer 120 can absorb and attenuate a spatially incident electromagnetic signal, to reduce or eliminate a reflected electromagnetic signal, and help reduce interference caused by an unwanted electromagnetic signal. For example, the wave-absorbing material of the high dielectric layer 120 may include an iron-silicon aluminum material.

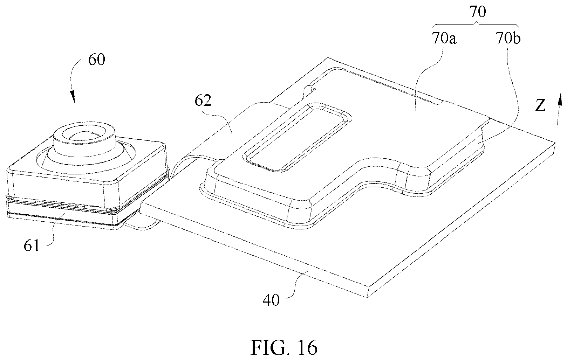

In some implementable manners, FIG. 16 schematically shows a partial structure of the electronic device. An shown in FIG. 16, unlike the foregoing embodiment in which the shielding member 70 includes the shielding frame 71 and the shielding cover 72, the shielding member 70 in this embodiment is of an integrally formed structure.

The shielding member 70 is connected to the mainboard 40. For example, the shielding member 70 is welded to the mainboard 40. Accommodating space is formed between the shielding member 70 and the mainboard 40. The first connection terminal 41 and the second connection terminal 63 are located in the accommodating space. The shielding member 70 is electrically connected to the ground terminal 42. The second connection terminal 63 is electrically connected to the shielding member 70.

In some examples, the shielding member 70 includes a top wall 70a and a side wall 70b. The side wall 70b is connected to the mainboard 40. The side wall 70b is electrically connected to the ground terminal 42 of the mainboard 40. For example, the shielding member 70 is welded to the ground terminal 42. The top wall 70a is electrically connected to the second connection terminal 63. The first connection terminal 41, the second connection terminal 63, the top wall 70a, and the side wall 70b may be grounded by using the ground terminal 42 of the mainboard 40.

The side wall 70b may be of an annular structure. The side wall 70b of the shielding member 70 is disposed around the first connection terminal 41. Therefore, in any direction, the shielding member 70 can have a good shielding effect on the first connection terminal 41. A shape of the side wall 70b may be regular, such as a rectangle or a circle. A shape of the side wall 70b may alternatively be irregular. This is not specifically limited in this application. In some examples, the side wall 70b may also have a notch, and the side wall 70b is disconnected and discontinuous at the notch, so that the side wall 70b is not of a continuous annular structure.

A surface that is of the second connection terminal 63 and that faces away from the first connection terminal 41 is bonded to the top wall 70a of the shielding member 70 by using a conductive adhesive, so that the second connection terminal 63 is electrically connected to the top wall 70a of the shielding member 70. An assembly manner may be but is not limited to the following: After the second connection terminal 63 is assembled with the first connection terminal 41, the conductive adhesive is disposed on the surface that is of the second connection terminal 63 and that faces away from the first connection terminal 41. Then, the shielding member 70 is assembled with the mainboard 40. After the shielding member 70 is assembled with the mainboard 40, the top wall 70a of the shielding member 70 is bonded to the conductive adhesive.

The electronic device 10 further includes a reinforcement member 100. The reinforcement member 100 is disposed on a side that is of the second connection terminal 63 and that faces away from the first connection terminal 41. The reinforcement member 100 is of a conductive structure. The reinforcement member 100 is electrically connected to the second connection terminal 63. The reinforcement member 100 is electrically connected to the top wall 70a of the shielding member 70.

The reinforcement member 100 may provide protection for the second connection terminal 63, to effectively avoid a case in which structural damage occurs in the second connection terminal 63 because the second connection terminal 63 is impacted by an external force. The shielding member 70 may apply compressive stress to the reinforcement member 100 toward the second connection terminal 63, to ensure connection reliability and stability between the first connection terminal 41 and the second connection terminal 63, and reduce a possibility that the second connection terminal 63 is removed from the first connection terminal 41 and is in a disconnected state.

In some examples, the top wall 70a of the shielding member 70 directly abuts against the reinforcement member 100. The top wall 70a of the shielding member 70 is in direct contact with the reinforcement member 100 to implement electrical connection, so that there is no need to dispose an additional structural member for implementing electrical connection between the shielding member 70 and the reinforcement member 100. This helps reduce a quantity of used parts and assembly operations. The top wall 70a of the shielding member 70 is located on a side that is of the reinforcement member 100 and that faces away from the mainboard 40. After the shielding member 70 is assembled with the mainboard 40, the top wall 70a of the shielding member 70 may directly abut against the reinforcement member 100. The top wall 70a of the shielding member 70 may apply compressive stress to the reinforcement member 100 and the second connection terminal 63, to ensure connection stability between the second connection terminal 63 and the first connection terminal 41.

In some examples, the electronic device 10 further includes a conductive member 110. The conductive member 110 is disposed between the top wall 70a of the shielding member 70 and the reinforcement member 100. The conductive member 110 electrically connects the top wall 70a of the shielding member 70 and the reinforcement member 100. The conductive member 110 is disposed between the top wall 70a of the shielding member 70 and the reinforcement member 100. The conductive member 110 may implement electrical connection between the shielding member 70 and the reinforcement member 100. After the shielding member 70 is assembled with the mainboard 40, the top wall 70a of the shielding member 70 and the reinforcement member 100 may jointly press against the conductive member 110, to ensure good contact between the conductive member 110 and each of the shielding member 70 and the reinforcement member 100, and maintain stability of an electrical connection state between the conductive member 110 and each of the shielding member 70 and the reinforcement member 100. For example, the conductive member 110 may be of a flexible structure, and has compressible and deformable performance. The conductive member 110 may be compressed and deformed. Therefore, when a surface of at least one of the shielding member 70 and the reinforcement member 100 is uneven, the conductive member 110 may perform compensation through deformation thereof, to ensure that a close fitted and contact state is maintained between the shielding member 70 and the conductive member 110 and between the reinforcement member 100 and the conductive member 110. In this way, a good electrical connection state is maintained between the shielding member 70 and the reinforcement member 100, to help reduce impedance. For example, the conductive member 110 may be a conductive fabric or a conductive adhesive layer.

In some examples, the reinforcement member 100 is capacitively coupled to the top wall 70a of the shielding member 70, thereby implementing an equivalent electrical connection effect between the reinforcement member 100 and the shielding member 70. A capacitor with relatively large capacitance may be equivalently formed between the reinforcement member 100 and the top wall 70a of the shielding member 70, so that an electrical signal can be coupled from one of the reinforcement member 100 and the shielding member 70 to the other thereof. The reinforcement member 100 is not in direct contact with the shielding member 70, so that a case in which poor contact occurs between the shielding member 70 and the reinforcement member 100 can be avoided, thereby reducing a possibility that a passive inter-modulation (Passive Inter-Modulation, PIM) problem and a spurious emission (RSE) problem are generated due to poor contact.

In some examples, the electronic device 10 further includes a high dielectric layer 120. The high dielectric layer 120 is disposed between the reinforcement member 100 and the top wall 70a of the shielding member 70. When the shielding member 70, the reinforcement member 100, and the high dielectric layer 120 are assembled, the top wall 70a of the shielding member 70 and the reinforcement member 100 may jointly compress the high dielectric layer 120. The shielding member 70, the reinforcement member 100, and the high dielectric layer 120 form a capacitive coupling.

The shielding member 70 and the reinforcement member 100 each are in non-electrical contact with the high dielectric layer 120. There is no problem of poor contact in the capacitive coupling manner. Therefore, there is no requirement on stability of contact resistance between the high dielectric layer 120 and each of the shielding member 70 and the reinforcement member 100, so that surface processing such as nickel plating and gold plating does not need to be performed on the shielding member 70 and the reinforcement member 100. In addition, a location for disposing the high dielectric layer 120 may be freely and flexibly selected based on a design requirement.

In some examples, the shielding member 70 has an avoidance hole 130. The circuit board 62 passes through the avoidance hole 130.

In some examples, an outer surface of the shielding member 70 is provided with an insulating layer 140. The insulating layer 140 disposed on the shielding member 70 may help maintain a good insulation and isolation state between the shielding member 70 and another conductive structural member. If the shielding member 70 is not provided with the insulating layer 140, there is a case in which the shielding member 70 is electrically connected to another conductive structural member. If there is poor contact between the shielding member 70 and another conductive structural member, there is a possibility that a passive inter-modulation (Passive Inter-Modulation, PIM) problem and a spurious emission (RSE) problem are generated between the shielding member 70 and the another conductive structural member. The outer surface of the shielding member 70 in this application is provided with the insulating layer 140, so that a possibility of the foregoing problem can be effectively reduced.

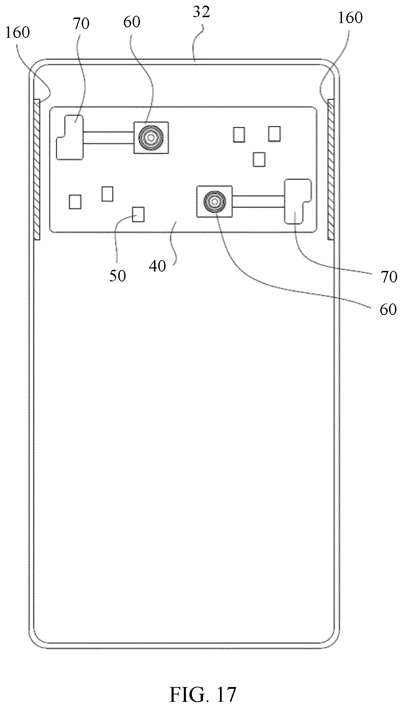

In some implementable manners, FIG. 17 schematically shows a partial structure of the electronic device. The electronic device 10 may include one or more camera apparatuses 60. For each camera apparatus 60, a corresponding shielding member 70 may be disposed in any manner in the foregoing embodiments. As shown in FIG. 17, the electronic device 10 further includes an antenna 160. With reference to FIG. 1 to FIG. 3, the housing 30 includes a rear cover 31 and a frame 32. The rear cover 31 may be connected to the frame 32. The antenna 160 is disposed on the frame 32. For example, the antenna 160 is disposed on an inner wall that is of the frame 32 and that faces the mainboard 40. The first connection terminal 41, the second connection terminal 63, and the shielding member 70 are disposed close to the antenna 160. The first connection terminal 41, the second connection terminal 63, and the shielding member 70 may be disposed in an edge region of the mainboard 40, so that the edge region of the mainboard 40 can be effectively used, to improve utilization of the mainboard 40. The shielding member 70 may provide effective shielding for the first connection terminal 41 and the second connection terminal 63. Therefore, when the antenna 160 is in a working state of radiating a wireless signal, an electromagnetic signal generated by the antenna 160 does not easily interfere with the first connection terminal 41 and the second connection terminal 63, thereby reducing a possibility that the antenna 160 adversely affects the camera apparatus 60 when the camera apparatus 60 performs a shooting function.

In some examples, an electronic element 150 is disposed on the mainboard 40. The electronic element 150 is disposed in the accommodating space 180. The shielding member 70 may have a shielding effect on the electronic element 150. When the electronic element 150 is in a working state, an electromagnetic signal transmitted by the electronic element 150 is not easily propagated to the antenna 160 that is located on an outer side of the shielding member 70 and that is relatively close to the electronic element 150. This effectively reduces a possibility that the electronic element 150 causes signal interference to the antenna 160.

In some examples, as shown in Table 1, comparison between related data of the electronic device 10 in this embodiment of this application and the electronic device 10 in the related technology is described by using an example.

**Table 1:**

| Antenna frequency band | | Isolation |
|---|---|---|
| N1/N3/B39 | No shielding member 70 | -41.2 dB |
| | The shielding member 70 is electrically connected to the reinforcement member 100. | -50.7 dB |
| N41/WIFI2.4GHz | No shielding member 70 | -40.2 dB |
| | The shielding member 70 is electrically connected to the reinforcement member 100. | -50.1 dB |

A working frequency band of the antenna 160 may support an N1 frequency band, an N3 frequency band, and a B39 frequency band. When the antenna 160 works in these frequency bands, if the shielding member 70 is not disposed on an exterior of the connector formed by the first connection terminal 41 and the second connection terminal 63, isolation between the antenna 160 and the connector formed by the first connection terminal 41 and the second connection terminal 63 may be -41.2 dB. The shielding member 70 is disposed on an exterior of the connector formed by the first connection terminal 41 and the second connection terminal 63 in this application. Therefore, when the antenna 160 works in these frequency bands, isolation between the antenna 160 and the connector may be -50.7 dB, so that isolation can be increased. Therefore, the isolation between the antenna 160 and the connector meets an isolation requirement, thereby reducing a possibility of signal interference. For example, the camera apparatus 60 may be a rear-facing camera of the electronic device 10.

It should be noted that the isolation is used to quantitatively represent strength of electromagnetic coupling in a unit of dB.

The working frequency band of the antenna 160 may support an N41 frequency band and a WIFI2.4 GHz frequency band. When the antenna 160 works in these frequency bands, if the shielding member 70 is not disposed on an exterior of the connector formed by the first connection terminal 41 and the second connection terminal 63, isolation between the antenna 160 and the connector formed by the first connection terminal 41 and the second connection terminal 63 may be -40.2 dB. The shielding member 70 is disposed at the connector formed on an exterior of the first connection terminal 41 and the second connection terminal 63 in this application. Therefore, when the antenna 160 works in these frequency bands, isolation between the antenna 160 and the connector may be -50.1 dB, so that isolation can increased. Therefore, the isolation between the antenna 160 and the connector meets an isolation requirement, thereby reducing a possibility of signal interference.

In some examples, in the related technology, the shielding member 70 is not disposed on an exterior of the connector formed by the first connection terminal 41 and the second connection terminal 63. In an environment with an electromagnetic signal, a maximum value of electric field strength measurement values at locations of the first connection terminal 41 and the second connection terminal 63 may be 42 dB V/m. The shielding member 70 is disposed on an exterior of the connector formed by the first connection terminal 41 and the second connection terminal 63 in this application. In a same environment, a maximum value of electric field strength measurement values at locations of the first connection terminal 41 and the second connection terminal 63 may be 26 dB V/m, so that an optimization of 16 dB V/m is relatively achieved. Therefore, the shielding member 70 is disposed, so that the first connection terminal 41 and the second connection terminal 63 can be effectively protected, thereby reducing signal interference.

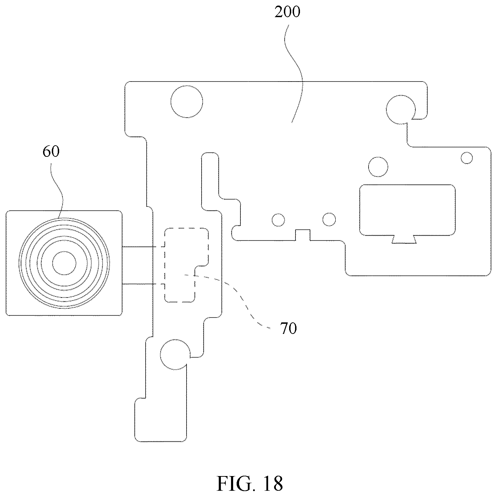

In some implementable manners, FIG. 18 schematically shows a partial cross-sectional structure of the electronic device. As shown in FIG. 18, the electronic device 10 further includes a metal bracket 200. The mainboard 40 may be connected to the metal bracket 200. The metal bracket 200 is used to provide support and a mounting base for the mainboard 40. A partial region of the metal bracket 200 may be located on one side of the shielding member 70. The shielding member 70 may be located between the mainboard 40 and the metal bracket 200. The shielding member 70 is grounded and covers the exterior of the connector formed by the first connection terminal 41 and the second connection terminal 63. Therefore, the shielding member 70 may effectively isolate the metal bracket 200 and the connector formed by the first connection terminal 41 and the second connection terminal 63, thereby reducing a possibility of electromagnetic signal interference on the connector formed by the first connection terminal 41 and the second connection terminal 63 because the metal bracket 200 is disposed.

The outer surface of the shielding member 70 may have the insulating layer 140, so that an insulation and isolation state is maintained between the metal bracket 200 and the shielding member 70, and no electrical connection occurs between the metal bracket 200 and the shielding member 70.

In the descriptions of the embodiments of this application, it should be noted that, unless otherwise explicitly specified and defined, the terms "mount", "communicate", and "connect" should be understood in a broadest sense, for example, may be a fixed connection, an indirect connection by using an intermediate medium, or a connection between interiors of two elements or an interaction relationship between the two elements. A person of ordinary skill in the art may understand specific meanings of the foregoing terms in the embodiments of this application based on a specific situation.

In the embodiments of this application, it does not indicate or imply that an apparatus or an element needs to have a particular orientation or needs to be constructed and operated in a particular orientation, and therefore should not be construed as a limitation on the embodiments of this application. In the descriptions of the embodiments of this application, "a plurality of" means two or more, unless otherwise specifically specified.

The terms "first", "second", "third", "fourth", and the like (if existent) in the specification, claims, and accompanying drawings of the embodiments of this application are used to distinguish between similar objects, but are not necessarily used to describe a particular order or sequence. It should be understood that the data termed in such a way is interchangeable in proper situations, so that the embodiments of this application that are described herein can be implemented in orders other than the order illustrated or described herein. In addition, the terms "include", "have", and any variation thereof are intended to cover non-exclusive inclusions. For example, a process, a method, a system, a product, or a device that includes a series of steps or units is not necessarily limited to those steps or units that are clearly listed, but may include other steps or units that are not clearly listed or are inherent to the process, method, product, or device.

The term "a plurality of" in this specification means two or more. In this specification, the term "and/or" is merely used to describe an association relationship between associated objects, and indicates that three relationships may exist. For example, A and/or B may indicate the following three cases: Only A exists, both A and B exist, and only B exists. In addition, the character "/" in this specification usually indicates an "or" relationship between associated objects. In a formula, the character "/" indicates that the associated objects are in a "division" relationship.

It may be understood that various numeric numbers used in the embodiments of this application are merely for differentiation for ease of description, and are not intended to limit the scope of the embodiments of this application.

It may be understood that in the embodiments of this application, sequence numbers of the foregoing processes do not mean execution sequences. The execution sequences of the processes should be determined according to functions and internal logic of the processes, and should not be construed as any limitation on the implementation processes of the embodiments of this application.

## Claims

1. An electronic device, comprising:
a mainboard, comprising a first connection terminal and a ground terminal;
a camera apparatus, comprising a camera module, a circuit board, and a second connection terminal, wherein the camera module is electrically connected to the circuit board, the second connection terminal is electrically connected to the circuit board, and the first connection terminal is electrically connected to the second connection terminal; and
a shielding member, wherein accommodating space is formed between the shielding member and the mainboard, the first connection terminal and the second connection terminal are located in the accommodating space, the shielding member comprises a shielding frame and a shielding cover that are electrically connected, the shielding frame is connected to the mainboard, the shielding frame is electrically connected to the ground terminal, the shielding cover is connected to the shielding frame, and the second connection terminal is electrically connected to the shielding cover.

2. The electronic device according to claim 1, wherein the shielding frame is of an annular structure, and the first connection terminal is located in the shielding frame.

3. The electronic device according to claim 1 or 2, wherein the shielding frame comprises a bottom flange, a first side plate, and a top flange, both the bottom flange and the top flange are connected to the first side plate, the bottom flange is electrically connected to the ground terminal, and an outer surface that is of the top flange and that faces away from the mainboard is electrically connected to an inner surface that is of the shielding cover and that faces the mainboard.

4. The electronic device according to claim 3, wherein the outer surface that is of the top flange and that faces away from the mainboard directly abuts against the inner surface that is of the shielding cover and that faces the mainboard, so that the top flange is electrically connected to the shielding cover, and a width of at least a part of the top flange is greater than a width the bottom flange.

5. The electronic device according to claim 3, wherein the shielding cover and the first side plate are snap-fitted with each other.

6. The electronic device according to claim 5, wherein a snap-in part is disposed on one of the shielding cover and the first side plate, a fitting part is disposed on the other thereof, and the snap-in part is snap-fitted with the fitting part.

7. The electronic device according to claim 6, wherein the shielding cover comprises a top plate and a second side plate that are connected to each other, the snap-in part is disposed on one of the first side plate and the second side plate, the fitting part is disposed on the other thereof, the first connection terminal and the second connection terminal are disposed between the top plate and the mainboard, and the outer surface that is of the top flange and that faces away from the mainboard is electrically connected to an inner surface that is of the top plate and that faces the mainboard.

8. The electronic device according to claim 7, wherein there are a plurality of second side plates, and there is a gap between two adjacent second side plates.

9. The electronic device according to claim 7, wherein the outer surface that is of the top flange and that faces away from the mainboard directly abuts against the inner surface that is of the top plate and that faces the mainboard, so that the top flange is electrically connected to the top plate.

10. The electronic device according to any one of claims 1 to 9, wherein the shielding cover and the shielding frame are snap-fitted with each other.

11. The electronic device according to any one of claims 1 to 10, wherein a surface that is of the second connection terminal and that faces away from the first connection terminal is bonded to the shielding cover by using a conductive adhesive, so that the second connection terminal is electrically connected to the shielding cover.

12. The electronic device according to any one of claims 1 to 10, wherein the electronic device further comprises a reinforcement member, at least a part of the reinforcement member is disposed on a side that is of the second connection terminal and that faces away from the first connection terminal, the reinforcement member is of a conductive structure, the reinforcement member is electrically connected to the second connection terminal, and the reinforcement member is electrically connected to the shielding cover.

13. The electronic device according to claim 12, wherein the shielding cover directly abuts against the reinforcement member.

14. The electronic device according to claim 12, wherein the electronic device further comprises a conductive member, the conductive member is disposed between the shielding cover and the reinforcement member, and the conductive member electrically connects the shielding cover and the reinforcement member.

15. The electronic device according to claim 14, wherein the conductive member is of a flexible structure.

16. The electronic device according to claim 12, wherein the reinforcement member is capacitively coupled to the shielding cover.

17. The electronic device according to claim 16, wherein the electronic device further comprises a high dielectric layer, and the high dielectric layer is disposed between the reinforcement member and the shielding cover.

18. The electronic device according to claim 17, wherein a material of the high dielectric layer comprises a wave-absorbing material.

19. The electronic device according to any one of claims 1 to 18, wherein there is an avoidance hole between the shielding cover and the shielding frame, and the circuit board passes through the avoidance hole.

20. The electronic device according to any one of claims 1 to 19, wherein an outer surface of the shielding cover is provided with an insulating layer.

21. The electronic device according to any one of claims 1 to 20, wherein the electronic device further comprises an electronic element, the electronic element is disposed on the mainboard, the electronic element is disposed in the accommodating space, and the electronic element is spaced apart from the first connection terminal.

22. The electronic device according to any one of claims 1 to 21, wherein the electronic device comprises a housing and an antenna, the mainboard is disposed in the housing, the housing comprises a frame, the antenna is disposed on the frame, and the first connection terminal, the second connection terminal, and the shielding member are disposed close to the antenna.

23. A shielding member, applied to an electronic device, comprising:
a shielding frame and a shielding cover, wherein
the shielding cover is connected to the shielding frame, the shielding cover is connected to the shielding frame to form an accommodating cavity, the accommodating cavity has an opening, the shielding frame is used for grounding, and the shielding cover is electrically connected to the shielding frame.
